# EUROPÄISCHE PATENTSCHRIFT

(11) **EP 2 548 276 B1**
(45) Veröffentlichungstag und Bekanntmachung des Hinweises auf die Patenterteilung: **13.11.2013**
(21) Anmeldenummer: 11700432.5
(22) Anmeldetag: 18.01.2011
(51) Int. Cl.: G01R 21/00, H02J 3/00, H02J 13/00

(54) **VERFAHREN UND VORRICHTUNG ZUR ELEKTRISCHEN VERBRAUCHS- UND ERZEUGUNGSERFASSUNG**
METHOD AND APPARATUS FOR RECORDING ELECTRICAL CONSUMPTION AND PRODUCTION
PROCÉDÉ ET DISPOSITIF POUR L'ENREGISTREMENT DE LA CONSOMMATION ET DE LA GÉNÉRATION D'ÉLECTRICITÉ

(30) Priorität: 16.03.2010 DE 102010002914
(43) Veröffentlichungstag der Anmeldung: 23.01.2013
(73) Patentinhaber: Robert Bosch GmbH, 70442 Stuttgart (DE)
(72) Erfinder: FRIEDE, Wolfgang, 71636 Ludwigsburg (DE); DA SILVA, Pedro, 73230 Kirchheim (DE)
(86) Internationale Anmeldenummer: PCT/EP2011/050588
(87) Internationale Veröffentlichungsnummer: WO 2011/113623

(56) Entgegenhaltungen:
- EP-A2- 1 777 793
- WO-A1-2008/148418
- WO-A2-2007/041693
- US-A1- 2007 271 006

## Beschreibung

### Stand der Technik

Die Erfindung betrifft ein Verfahren zur elektrischen Verbrauchs- und Erzeugungserfassung in einem Energiemanagement-Netzwerk, welches mindestens eine Energiemanagementeinheit aufweist und wobei in einer Stromverteilung eine Anzahl von elektrischen Verbrauchern oder Verbrauchergruppen und eine Anzahl von Erzeugern mittels zugeordneten Bauelementen in Form von Schaltelementen und Energiezählern, welche von der Energiemanagementeinheit beeinflusst oder ausgewertet werden, verschaltet werden.

Die Erfindung betrifft weiterhin ein Energiemanagement in Form von mindestens einer Energiemanagementeinheit zur Optimierung von Lasten und Erzeugung in einem Energiemanagement-Netzwerk, wobei die Vorrichtung zum Anschluss in einer Stromverteilung wenigstens eines elektrischen Verbrauchers oder einer Verbrauchergruppe und mindestens eines Erzeugers diesen zugeordnete Bauelemente in Form von Schaltelementen und Energiezähler aufweist, welche über eine Verbindung zur Energiemanagementeinheit von dieser beeinflussbar oder auswertbar sind.

Derzeit wird in den meisten Fällen der elektrische Verbrauch von Haushalten mit mechanischen Wechselstrom- oder mit Drehstromzählern nach dem Induktionsprinzip gemessen. Diese ermitteln die über die Zeit integrierte Leistung (= Energie). In Sonderformen können sie mit mehreren Zählwerken Tag-/Nachtverbrauch oder Einspeisung/ Verbrauch getrennt zählen. Parallel existieren bereits elektronische Zähler, die über die Integration des Produkts aus Strom und Spannungswert die übertragene Leistung und damit die Energie ermitteln.

Energiemanagementsysteme mit entsprechender Software zur Energieverbrauchsoptimierung sind inzwischen für Wohn- und gewerbliche Gebäude bekannt. Allerdings sind alle am Markt befindlichen Lösungen nur mit einem erheblichen Installationsaufwand in Betrieb zu nehmen. Zudem lassen sich derartige Systeme nur eingeschränkt nutzen.

Derartige Lösungen basieren beispielsweise auf einer Energiemanagementsoftware, die mit einer installierten Gebäudeleittechnik (GLT) verbunden wird. Die vorhandenen Softwarelösungen sind mit den vorhandenen Sensoren begrenzt in der Lage, die energetischen IST-Zustände der Gebäudetechnik zu erfassen, die mit dieser GLT verbunden ist. Eine automatische Steuerung anhand vorgegebener SOLL-Parameter existiert aber nicht. Bei den am Markt angebotenen Energiemanagementgeräten, bei denen beispielsweise die der Firma ENNOVATIS bereits einen hohen innovativen Stand erreicht haben, müssen Lasten und Erzeuger separat mit dem Energiemanagementsystem verdrahtet werden. Lokalisierungsinformationen müssen weiterhin aufwendig programmiert werden. Zudem können nur IST-Zustände erfasst und wiedergegeben werden.

So beschreibt beispielsweise die DE 10 2004 055088 A1 ein System zur Erfassung und Speicherung von für die Verbrauchsermittlung und -analyse einer Immobilie erforderlichen Messdaten, wie Innen- und Außentemperaturen, odgl., sowie zur Steuerung des Verbrauchs der Immobilie, mit einem Datenlogger, mit einem Datenanalysator, mit mindestens einem für die Messdatenerfassung erforderlichen Eingang, mit mindestens einem Steuerungsausgang und mit mindestens einer Schnittstelle zur Datenauslesung. Dabei ist vorgesehen, dass sämtliche Komponenten auf einer einzigen, kompakten Platine angeordnet sind. Ein entsprechendes Verfahren sieht dabei vor, dass nach erstmaliger Programmierung des Systems mittels einer Programmiereinheit (PC) das System aufgrund seiner Komponenten eigenständig arbeitet.

Eine noch nicht veröffentlichte Anmeldung der Anmelderin mit dem internen Aktenzeichen R.328907 beschreibt ein Verfahren und eine Vorrichtung zur Durchführung des Verfahrens für ein Energiemanagement zur Optimierung von Lasten und Erzeugung in einem Energiemanagement-Netzwerk, welches mindestens eine Energiemanagementeinheit aufweist, wobei der IST-Zustand der Energieverbraucher bzw. der Energieerzeuger über kombinierte Energieversorgungs-/Kommunikationsleitungen an die Energiemanagementeinheit übertragen und damit eine eigenständige Konfiguration der Energiemanagementeinheit durchgeführt wird, wobei mindestens ein SOLL-Parameter an der Energiemanagementeinheit eingestellt wird.

Werden eine Vielzahl unterschiedlicher Stromtarife, z.B. für Haushaltsstrom, Wärmepumpenstrom, Elektrofahrzeugstrom, Photovoltaik-Einspeisung (PV-Einspeisung), Kraft-Wärme-Kopplung-Einspeisung (KWK-Einspeisung), eingesetzt, wird der Anschluss im Haus derzeit mit einer Vielzahl von Einspeise- und Verbrauchs-Zählern realisiert. In Forschungsprojekten werden so genannte "Smart Meter" entwickelt, die neben der Erfassung der übertragenen Energie auch Schaltinformationen anhand von Energiepreisen an die Verbraucher weitergegeben. Diese gehen aber davon aus, dass der Haushalt Kunde nur eines Stromanbieters ist. Die DE 20218473 U1, entsprechend der EP 1 339 153 A3, beschreibt eine derartige Einrichtung zum Anschluss eines Gebäudes odgl. mit wenigstens einem Verbraucher und/ oder Erzeuger von elektrischer Energie an ein elektrisches Niederspannungsnetz, welches wenigstens je ein dem Verbraucher bzw. Erzeuger zugeordnetes Bauelement in Form eines Schalters und/ oder Messelements und eine Informationsverarbeitungseinheit, die eine bidirektionale Kommunikation zwischen einer externen Netzleitstelle und dem Verbraucher bzw. Erzeuger und/ oder dem Bauelement ermöglicht, aufweist.

Es ist daher Aufgabe der Erfindung, ein Verfahren bereitzustellen, welches es ermöglicht, Elektrizitätsdienstleistungen bzw. elektrische Energie für unterschiedliche Verbraucher und ggf. Tageszeiten von verschiedenen Anbietern zu unabhängigen Tarifen zu beziehen, selbst erzeugte elektrische Energie von unterschiedlichen Erzeugern und ggf. zu unterschiedlichen Tageszeiten an verschiedene Anbieter zu unabhängigen Tarifen abzugeben und dabei ggf. selbst erzeugte Energie, soweit es sinnvoll ist möglichst wirtschaftlich selbst zu verbrauchen.

Es ist weiterhin Aufgabe der Erfindung, eine zur Durchführung des Verfahrens entsprechende Vorrichtung bereitzustellen.

### Offenbarung der Erfindung

Die die Vorrichtung betreffende Aufgabe wird dadurch gelöst, dass die Schaltelemente in Form einer Schaltmatrix angeordnet sind und damit Energiezähler für Erzeuger und Verbraucher oder Verbrauchergruppen in Serie oder parallel, abhängig von einem jeweiligen aktuellen Einspeise- oder Verbrauchstarif, die von der Energiemanagementeinheit von unterschiedlichen Energiedienstleistern empfangen werden, schaltbar sind, wobei, in der Schaltmatrix integriert, jedem Erzeuger und jedem Verbraucher oder jeder Verbrauchergruppe ein Energiezähler und ein oder mehrere Energieflussrichtungsmesser zur Abrechnung zugeordnet sind.

Die das Verfahren betreffende Aufgabe wird dadurch gelöst, dass mittels eines Schaltalgorithmus die Verbraucher oder Verbrauchergruppen beginnend mit einem aktuell höchsten Bezugspreis und die Erzeuger beginnend mit einer niedrigsten Einspeisevergütung indiziert und mittels der Schaltelemente die Erzeuger und Verbraucher oder Verbrauchergruppen derart gekoppelt werden, dass die Anzahl der Kopplungen von Verbrauchern oder Verbrauchergruppen mit hohen Bezugspreisen mit Erzeugern mit niedrigen Einspeisevergütungen maximiert wird, so dass möglichst viele Verbraucher oder Verbrauchergruppen direkt von den Erzeugern versorgt werden können.

Mit dem Verfahren und der Vorrichtung kann insbesondere ein effizientes Energiemanagementsystem für Wohn- und Gewerbebauten bereitgestellt werden, bei dem eine optimale Ausnutzung preiswert erzeugter Energie zur Deckung eines Verbrauchs mit hohen Kosten erzielt werden, wobei aktuelle Einspeise- und Verbrauchstarife verschiedener Dienstleister berücksichtigt werden können. Bei diesem Energiemanagement handelt es sich insbesondere um ein Zählen und Bilanzieren von Energieverbräuchen und Energiebereitstellungen. Dies ist insbesondere im Hinblick auf zukünftige Energiekonzepte für private, öffentliche oder auch gewerbliche Gebäude oder Einrichtungen von Bedeutung, bei denen zukünftig neben einem reinen Energiebezug aus dem Netz auch eigene Erzeuger, wie beispielsweise Photovoltaik-Einspeisung (PV-Einspeisung), Kraft-Wärme-Kopplung-Einspeisung (KWK-Einspeisung) effizient genutzt werden. Auf der Verbraucherseite sind beispielsweise Haushaltsgeräte (Waschmaschine, Spülmaschine, Herd etc.), Wärmepumpen, Elektroheizungen oder zukünftig vermehrt auch Ladestationen für Elektrofahrzeuge bzw. so genannte PHEVs (plug in hybrid electric vehicle) zu nennen. Hinzu kommen noch Speicherkonzepte, wie Photovoltaik-Zwischenspeicher, Batteriespeicher bzw. Batterie-Ladestationen.

Erzeuger, Verbraucher und Speicher werden, wie bereits heute üblich, zu unterschiedlichen Preisen ihre Energie beziehen bzw. einspeisen, wobei sich die Preisunterschiede sich auf der Erzeugerseite z. B. aufgrund der Förderung zur Reduktion eines CO₂-Ausstoßes, z.B. im Umlageverfahren gemäß dem EEG (Erneuerbare-Energie-Gesetz) oder KWKG (Kraft-Wärme-Kopplungsgesetz), aufgrund unterschiedlicher Bonuszahlungen für Einspeisungen zu bestimmten Zeiten oder zentral steuerbarer Einspeisungen oder aufgrund sonstiger Marktanreize von Regierung oder Netzbetreiber ergeben. Auf der Verbraucherseite ergeben sich die Unterschiede aufgrund der Möglichkeit einer Umsatzsteigerung für Energieversorger (z. B. für Heizstrom, Wärmepumpenstrom oder PHEV-Strom), aufgrund einer Boni-Regelung für den Verbrauch zu bestimmten Zeiten oder einem zentral steuerbaren Verbrauch (z. B. bestimmte Sperrzeiten für den Betrieb von Wärmepumpen) sowie aufgrund von Marktanreizen von Regierung oder Netzbetreiber. Für beide Seiten kann der Bezug bzw. die Einspeisung bei unterschiedlichen Anbietern zu zeitlich wechselnden Tarifen führen, die mit dem erfindungsgemäßen Konzept berücksichtigt werden können.

Für jeden Verbraucher bzw. für jede Verbrauchergruppe und jeden Erzeuger sind in einer bevorzugten Ausführungsform jeweils drei Schaltelemente m_{A}, m_{B}, m_{C} bzw. n_{D}, n_{E}, n_{F}, ein Energiezähler und ein oder zwei Energieflussrichtungsmesser Rm_{C}, Rm_{A} bzw. Rn_{D}, Rn_{F} zugeordnet, wobei einer der Energieflussrichtungsmesser in einem der Energiezähler integriert sein kann. Damit lässt sich, ähnlich einer Multi-Switch-Anordnung, eine Schaltmatrix realisieren, mit der die den Erzeugern und Verbrauchern individuell zugeordneten Energiezähler für die Eigennutzung des Stroms in Reihe und für die direkte Einspeisung ins Netz und den direkten Bezug des Stroms aus dem Netz parallel geschaltet werden können. Außerdem sorgt die Messung der Stromrichtung dafür, dass jeder Verbraucher und jeder Erzeuger Energie nur mit demjenigen Energiezähler abrechnet, der ihm auch zugeordnet ist.

Eine vorteilhafte Ausführungsvariante sieht vor, dass die jeweils drei Schaltelemente m_{A}, m_{B}, mc bzw. n_{D}, n_{E}, n_{F}, der Energiezähler und die ein oder zwei Energieflussrichtungsmesser Rm_{C}, Rm_{A} bzw. Rn_{D}, Rn_{F} für jeden Verbraucher bzw. für jede Verbrauchergruppe und jeden Erzeuger in Modulen zusammengefasst sind, wobei den Verbrauchern bzw. den Verbrauchergruppen und den Erzeugern zwei unterschiedliche Modul-Typen 1 und 2 zugeordnet sind. Im Hinblick auf eine einfache und auch kostengünstige Installation können mit diesem modularen Konzept sehr einfach unterschiedliche Stromverteilungssysteme mit einer unterschiedlichen Anzahl von Verbrauchern oder Verbrauchergruppen und Erzeugern realisiert werden. Eine spätere Erweiterung der Anlage mit zusätzlichen Verbrauchern bzw. Erzeugern ist damit ebenfalls möglich.

Im Hinblick auf eine vereinfachte Montage in der Stromverteilung ist es vorteilhaft, wenn die Modultypen 1 und 2 für die jeweiligen Verbraucher oder die jeweiligen Verbrauchergruppen und für die jeweiligen Erzeuger aneinanderreihbar sind und Anschlüsse für vorgeschaltete und nachgeschaltete Module aufweisen.

Alternativ können der Modultyp 1 und 2 für die jeweiligen Verbraucher oder die jeweiligen Verbrauchergruppen und für die jeweiligen Erzeuger Anschlüsse für gemeinsame Koppelpunkte 1 und 2 innerhalb der Stromverteilung aufweisen, was ebenfalls die Montage in der Stromverteilung vereinfacht. Ein Tausch der Module ist in o.g. Fällen funktional entsprechend, wobei aber zu berücksichtigen ist, dass sich die Zählpfeile ändern, wenn getauscht wird.

In einer besonders bevorzugten Ausführungsvariante ist vorgesehen, dass die Energiezähler, die Energieflussrichtungsmesser sowie die Schaltelemente als elektronische Bauelemente ausgeführt sind und die Auswertung und ein Schaltalgorithmus zur Ansteuerung der Schaltelemente als Software in der Energiemanagementeinheit implementiert ist. Dabei können die Schaltelemente sowohl als Halbleiter-Schalter oder als elektromechanische Leistungsschütze ausgebildet sein. Innerhalb der als zentralen Rechner ausgebildeten Energiemanagementeinheit können die unterschiedlichen Einspeise- bzw. Verbrauchstarife ausgewertet, zwischengespeichert und zur Ansteuerung der Schaltelemente verarbeitet werden, wobei die Einspeise- bzw. Verbrauchstarife über entsprechende Informationskanäle, wie sie im eingangs erwähnten Stand der Technik beschrieben sind, zur Verfügung gestellt werden können.

Eine bevorzugte Verfahrensvariante sieht vor, dass in Abfragen ermittelt wird, ob, abhängig von den aktuellen Verbrauchspreisen und den Einspeisevergütungen der einzelnen Verbraucher oder Verbrauchergruppen sowie der Erzeuger, und/ oder abhängig von der Energieflussrichtung, es wirtschaftlich ist, weitere Verbraucher oder Erzeuger zur Kopplung dazu zuschalten oder ob wegen Zählung zu einem zu niedrigen Tarif Verbraucher oder Erzeuger von der Kopplung getrennt werden müssen.

Weiterhin kann im Hinblick auf eine optimale Ausnutzung von preiswert erzeugter Energie bzw. im Hinblick auf eine Vermeidung von teuerer Energie beim Bezug vorgesehen sein, dass bei Änderungen in der jeweiligen Einspeisevergütung für die Erzeuger und/ oder bei Änderungen der jeweiligen Verbrauchspreise für die Verbraucher oder Verbrauchergruppen eine erneute Indizierung für die Verbraucher oder Verbrauchergruppen und die Erzeuger durchgeführt und entsprechend die Kopplungen und deren Anzahl aktualisiert werden. Eine relevante Preisänderung liegt dann vor, wenn sich die Reihenfolge in einer Liste aller Einspeise- und Bezugspreise ändert, wobei in der Liste alle Preise mit positiven Vorzeichen eingetragen werden. Die Zeitpunkte der Abfrage können dabei vorgegeben werden.

Eine relevante Preisänderung liegt insbesondere vor, wenn kein Eigenverbrauch mehr sinnvoll ist. Daher kann vorgesehen sein, dass bei einer Tarifänderung, bei der die niedrigste Einspeisevergütung ≥ dem höchsten Verbrauchspreis ist, ein Eigenverbrauch unterbunden wird und eine direkte Einspeisung der von dem oder den Erzeugern erzeugte Energie in ein Netz erfolgt.

Um eine zu große Zahl von Schaltvorgängen zu vermeiden, kann in einer Verfahrensvariante vorgesehen sein, dass nach einer Reduzierung der Anzahl der gekoppelten Erzeuger und Verbraucher eine erneute Erhöhung der Anzahl für eine bestimmte Zeit unterbunden wird. Damit kann auch sichergestellt werden, dass nicht zu einem falschen Verbrauchstarif, d.h. zu niedrigen Tarif, verbraucht oder zu einem falschen Einspeisetarif, d.h. in diesem Fall zu hohen Tarif, eingespeist wird. Wenn ein Verbraucher bzw. ein Erzeuger ungekoppelt betrieben wird, obwohl es wirtschaftlicher ist, ihn an die Verteilung zu koppeln, dann wird Eigennutzung vermieden, aber jeder Verbraucher rechnet korrekt ab. Ein "Schaden" für den Nutzer entsteht dadurch, dass Strom für wenig Geld verkauft und für viel Geld zurückgekauft wird. Es wird aber nichts über einen falschen Zähler abgerechnet. Daher ist dieser Zustand unkritisch. Ist allerdings ein Erzeuger oder Verbraucher zu viel gekoppelt, so kann es passieren, dass z. B. die Haushaltsstromverbraucher mit Wärmepumpenstrom versorgt werden, was einem Verstoß gegen einen Wärmepumpenstromvertrag entspricht. Daher ist dieser Zustand zu vermeiden.

In einer Verfahrensvariante kann vorgesehen sein, dass der oder die aktuell ermittelten Einspeise- bzw. Verbrauchspreise, also die Vergütung oder der Preis des Zählers, der gerade aktiv zählt, steuerbaren Erzeugern bzw. Verbrauchern übermittelt werden, die dann entsprechend reagieren können. Dabei kann beispielsweise die Aufnahmeleistung des Verbrauchers oder die Erzeugerleistung angepasst werden, mit dem Ziel, dass eine Umschaltung der Kopplung vermieden wird. So kann diese Information auch dazu dienen, Verbraucher mit hohen Leistungsaufnahmen vorher zu warnen, dass aktuell eine Verbrauchstariferhöhung ansteht, und der Verbraucher die Leistungsaufnahme entsprechend reduziert oder der Verbraucher ganz abschaltet, was beispielsweise beim Betrieb von Speichern (z.B. Elektrospeicherheizung, Ladestationen etc.) besonders kosteneffizient sein kann.

Um Unterbrechungen der Verbindung zum Netz zu vermeiden, müssen bei jedem Schaltvorgang zuerst alle Schließvorgänge und dann alle Öffnungsvorgänge ausgeführt werden. Die Zeit zwischen Schließen und Öffnen muss so bemessen sein, dass die Schaltelement, die schließen sollen, sicher geschlossen sind, bevor andere Schaltelemente geöffnet werden. Dadurch wird auch die Belastung der Schaltelemente minimiert, da diese nie unter Last schalten müssen.

Die Erfindung wird im Folgenden anhand eines in den Figuren dargestellten Ausführungsbeispiels näher erläutert. Es zeigt:
Figur 1 eine Stromverteilung für Erzeuger und Verbraucher nach dem Stand der Technik,
Figur 2 eine flexible Stromverteilung für einen Erzeuger und zwei Verbraucher in einer erfindungsgemäßen Ausgestaltung,
Figur 3 eine Wertetabelle für verschiedene Anwendungsfälle für die in Figur 2 dargestellte Anordnung,
Figur 4 einen schematischen Aufbau eines Moduls nach einem Modul-Typ 1 für Verbraucher,
Figur 5 einen schematischen Aufbau eines Moduls nach einem Modul-Typ 2 für Erzeuger,
Figur 6 eine schematische Darstellung einer Stromverteilung in einem modularen Aufbau und
Figur 7 ein Ablaufdiagramm für einen Verfahrens-Algorithmus.

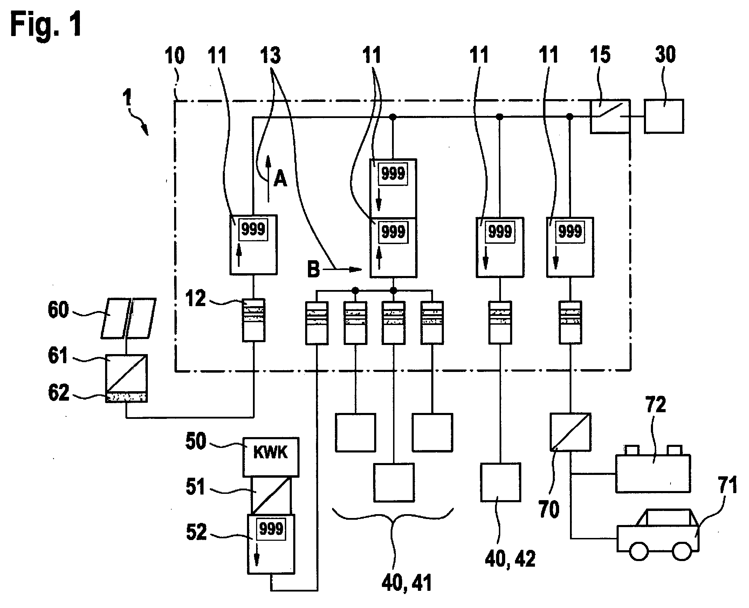

Figur 1 zeigt schematisch eine Stromverteilung 10 eines Energiemanagement-Netzwerkes 1 gemäß dem Stand der Technik.

Die Stromverteilung 10 ist eingangsseitig über einen Hauptschalter 15 bzw. Hauptsicherung mit einem Netz 30 für Niederspannung (230 V Wechselstrom oder 400 V Drehstrom) verbunden. Ausgangsseitig sind verschiedene Verbraucher 40 in Form von Haushaltsverbraucher 41 oder Verbrauchergruppen (z.B. Steckdosen, Raumbeleuchtung) über einen Energiezähler (1-Phasen-Wechselstrom- oder 3-Phasen-Drehstromzähler) sowie über Leitungsschutzschalter 12 (Schmelzsicherungen oder Sicherungsautomaten) entsprechend der Anzahl der Verbraucher bzw. Stromkreise mit dem Netz 30 verbunden. Zudem sind im gezeigten Beispiel separat über zwei weitere Energiezähler 11 und Leitungsschutzschalter 12 als Verbraucher 40 eine Wärmepumpe 42 sowie eine Ladestation 70 für ein Elektrofahrzeug 71 oder für eine Batterie 72 für das Elektrofahrzeug 71 am Netz angeschlossen.

Zusätzlich ist als Erzeuger eine Photovoltaik-Anlage 60 schematisch dargestellt, die die erzeugte elektrische Energie über Wechselrichter 61 und einer Trennstelle 62 ebenfalls in die Stromverteilung 10 einspeist, wobei zur Zählung der Energie ein separater Energiezähler 11 vorgesehen ist und eine Stromrichtung 13 in Flussrichtung A zum Netz 30 vorgesehen ist. Weiterhin dargestellt ist eine Kraftwärmekopplung 50, die die erzeugte elektrische Energie über Wechselrichter 51 und einen eigenen Erzeugungszähler 52 in die Stromverteilung 10 einspeist. Die Einspeisung erfolgt hier derart, dass die Stromrichtung 13 in Flussrichtung B erfolgt und somit ein direkter Eigenverbrauch dieser Energie ermöglicht werden kann. Zur Absicherung sind hier ebenfalls Leitungsschutzschalter 12 vorgesehen.

Für die Ermittlung des Verknüpfungspunktes von Erzeugern und Verbrauchern 40 ist es erforderlich, zu wissen, ob die Vergütung für den eingespeisten Strom höher oder niedriger als der Preis für verbrauchten Strom ist. Im gezeigten Beispiel ist die Einspeisung des Stroms der Photovoltaik-Anlage 60 direkt in das Netz 30 sinnvoll, da hierbei eine hoher Vergütungstarif gezahlt wird (Stromfluss A). Hingegen wird im Beispiel der Kraftwärmekopplung 50 nur ein vergleichsweise geringer Einspeisetarif vergütet, so dass ein direkter Verbrauch durch die Verbraucher 40, insbesondere der Haushaltsverbraucher 41, wirtschaftlich ist. Wird aktuell kein Strom verbraucht, kann dieser Strom über einen weiteren Energiezähler 11, der mit dem Energiezähler 11 für die Verbraucher 40 in Reihe geschaltet ist, aber nur eine zu diesem entgegen gesetzte Zählrichtung zulässt, ebenfalls in das Netz 30 eingespeist werden.

Bei der in Figur 1 dargestellten Anordnung handelt es sich um ein starres Konzept, welches hinsichtlich sich ändernder Konfigurationen bei den Erzeugern bzw. Verbrauchern 40 oder auch bei Tarifanpassung aufwendig neu konfiguriert bzw. auf der Hardware-Seite neu installiert werden muss.

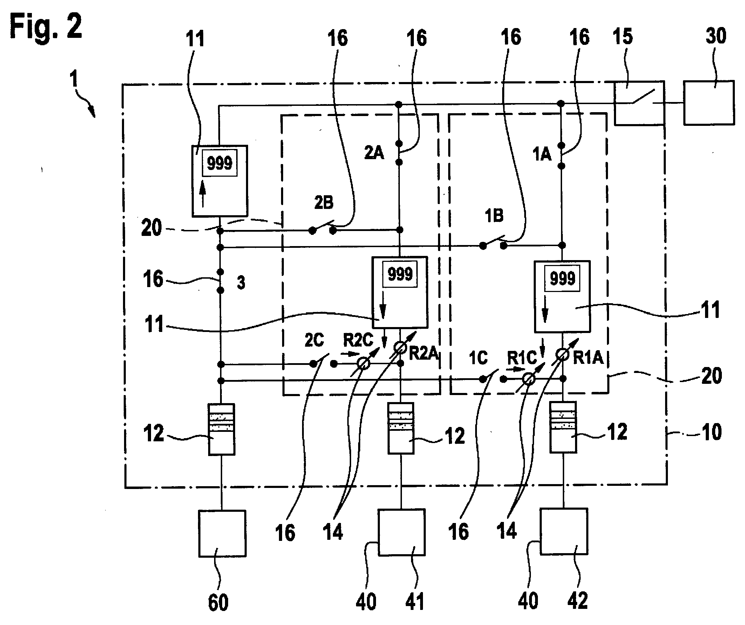

Ein zunächst vereinfachtes Modell für eine erfindungsgemäße Stromverteilung 10 eines Energiemanagement-Netzwerkes 1 ist in Figur 2 dargestellt.

Im gezeigten Beispiel ist nur eine Erzeugungsanlage in Form einer Photovoltaik-Anlage 60 sowie zwei Verbraucher 40 in Form von Haushaltsverbrauchern 41 und einer Wärmepumpe 42 dargestellt. Die Stromverteilung 10 ist über einen Hauptschalter 15 in Form einer Hauptsicherung mit dem Netz 30 für Niederspannung verbunden. Die Anlage besteht im Wesentlichen aus elektronischen Stromzählern 11 mit einer bestimmten Zählrichtung, die eine Rücklaufsperre aufweisen, Leitungsschutzschalter 12 in Form von Sicherungsautomaten für die verschiedenen Erzeuger- bzw. Verbraucherstromkreise, diverse mechanische oder als Halbleiter-Schütz ausgebildete Schaltelemente 16, deren Schalterstellung von einer in dieser Ansicht nicht dargestellten Energiemanagementeinheit beeinflussbar sind sowie aus Energieflussrichtungsmessern 14.

Für die beiden Verbraucher 40 sind zwei gleichartig aufgebaute Module 20 vorgesehen, die jeweils drei Schaltelemente 16 1_{A}, 1_{B,} 1_{C} bzw. 2_{A}, 2_{B}, 2_{C} ,einen Energiezähler 11 sowie zwei Energieflussrichtungsmesser 14 R1_{C}, R1_{A} bzw. R2_{C}, R2_{A} aufweisen. Dabei kann vorgesehen sein, dass jeweils einer der Energieflussrichtungsmesser 14 (R1_{A} bzw. R2_{A}) im jeweiligen Energiezähler 11 integriert sein kann, da ein elektronischer Zähler automatisch die Flussrichtung mitbestimmen kann. Für den Erzeuger ist in diesem vereinfachten Beispiel zunächst nur ein Schaltelement 16 (Nr. 3) und ein Energiezähler 11 vorgesehen.

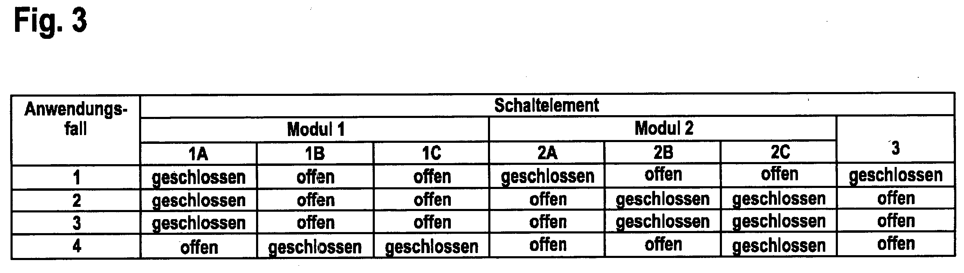

In den nachfolgend beschriebenen Anwendungsfällen wird aufgezeigt, welchen Zustand die Schaltelemente 16 besitzen, wenn unterschiedliche Einspeise- und Verbrauchstarife für die Photovoltaik-Anlage 60 und die Haushaltsverbraucher 41 und die Wärmepumpe 42 zu Grunde gelegt werden. Figur 3 zeigt in einer entsprechenden Tabelle die Schaltzustände der verschiedenen Schaltelemente.

### Fall 1:

Im in Figur 2 gezeigten Fall ist die Einspeisevergütung für die Photovoltaik-Anlage 60 höher als die Verbrauchstarife für die Haushaltsverbraucher 41 und die Wärmepumpe 42, so dass der komplette PV-Strom an das Netz 30 verkauft wird und der verbrauchte Strom aus dem Netz 30 bezogen wird. Die Schaltelemente 16 1_{A}, 2_{A} und 3 sind geschlossen. Dies entspricht auch der in Figur 1 gezeigten Situation.

### Fall 2:

Sinkt nun durch einen zeitlich veränderten Tarif die Einspeisevergütung für die Photovoltaik-Anlage 60 unter den Preis des Haushaltsstroms, ist es wirtschaftlich sinnvoll, den Haushaltsstrom für die Haushaltsverbraucher 41 mit Strom aus der Photovoltaik-Anlage 60 zu decken. Dafür müssen die Energiezähler 11 für die Photovoltaik-Anlage 60 und für die Haushaltsverbraucher 41 in Reihe geschaltet werden, so dass überschüssiger Strom aus der Photovoltaik-Anlage 60 und zusätzlich benötigter Haushaltsstrom je nach Verhältnis der Leistungen richtig verbucht werden. Daher sind in diesem Fall gegenüber Fall 1 die Schaltelemente 16 2_{B} und 2_{C} geschlossen sowie 2_{A} und 3 geöffnet.

### Fall 3:

Sinkt die Einspeisevergütung für die Photovoltaik-Anlage 60 weiter, so dass auch noch der Verbrauchstarif für die Wärmepumpe 42 unterschritten wird, wäre es sinnvoll, dass die Photovoltaik-Anlage 60 neben den Haushaltsverbrauchern 41 auch noch die Wärmepumpe 42 mit Strom versorgt, wobei allerdings vorrangig die Haushaltsverbraucher 41 mit Photovoltaik-Strom versorgt werden sollen. Daher bleiben in diesem Fall die Schaltzustände wie für Fall 2 erhalten (vergleiche Figur 3). In diesem Fall ist lediglich vorgesehen, die Richtungsmessung mit dem Energieflussrichtungsmesser 14 R2_{A} zu überwachen. Solange Strom bezogen wird, ist der Verbrauch der Haushaltsverbraucher 41 höher als die Erzeugung der Photovoltaik-Anlage 60, so dass die Wärmepumpe 42 aus dem Netz 30 versorgt werden muss. Dies wird daran erkannt, dass die Richtungsmessung mit dem Energieflussrichtungsmesser 14 R2_{A} einen Leistungsfluss in Richtung der Haushaltsverbraucher 41 feststellt.

### Fall 4:

In diesem Fall ist die Erzeugerleistung der Photovoltaik-Anlage 60 größer als der Verbrauch der Haushaltsverbraucher 41. Hier sind durch Schließen der Schaltelemente 16 1_{C} und 2_{C} beide Verbraucher parallel geschaltet. Durch Schließen des Schaltelementes 16 1_{B} wird dafür gesorgt, dass zusätzlich aus dem Netz 30 bezogener Strom als Wärmepumpenstrom gezählt wird. Überschüssiger PV-Strom, der den Verbrauch von Haushaltsverbrauchern 41 und Wärmepumpe 42 übersteigt, wird weiterhin über den Energiezähler 11 für die Photovoltaik-Anlage 60 erfasst.

Bei sinkender Erzeugungsleistung oder steigendem Verbrauch der Haushaltsverbraucher 41 muss hierbei überwacht werden, dass kein Strom, der als Wärmepumpenstrom vom Energiezähler 11 für die Wärmepumpe 42 gezählt wurde, zur Versorgung der Haushaltsverbraucher 41 über die Schaltelemente 16 1_{C} und 2_{C} dient. Dies wird durch eine Flussrichtungsumkehr im Energieflussrichtungsmesser 14 R1_{C} erkannt. Fließt hier Strom vom Energiezähler 11 für die Wärmepumpe 42 weg, muss zum o.g. Fall 3 zurück geschaltet werden.

Analog zu Fall 2, 3 und 4 können auch Fälle für einen Wärmepumpentarif, der höher als der Haushaltstarif ist, konstruiert werden. Dazu sind jeweils die Schaltelemente 16 1_{A}, 1_{B,} 1_{C} durch die Schaltelemente 16 2_{A}, 2_{B}, 2_{C} zu ersetzen und die Energieflussrichtungsmesser 14 entsprechend zu tauschen. Dieser Fall kann z.B. tagsüber eintreten, wenn ein Betrieb der Wärmepumpen 42 vom Netzbetreiber nicht erwünscht ist.

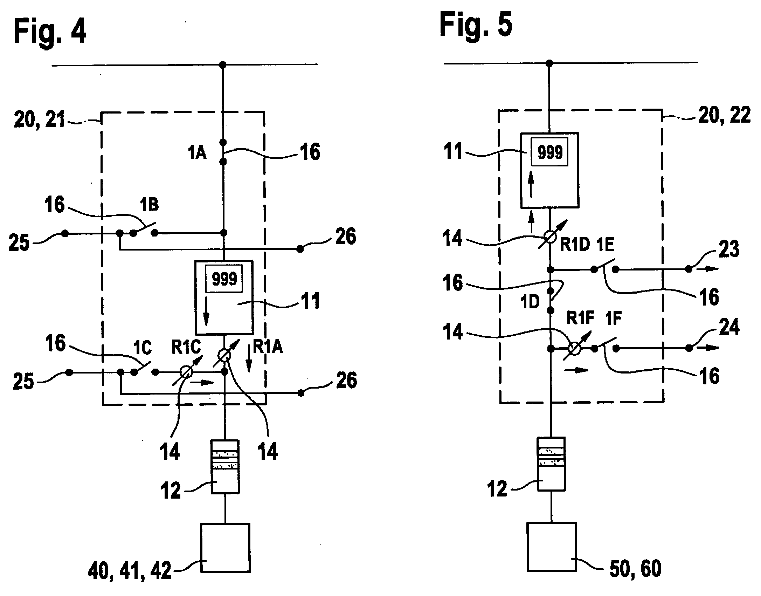

Figur 4 zeigt ein Modul 20, welches als Modultyp 1 21 für Verbraucher 40 (Haushaltsverbraucher 41, Wärmepumpen 42 etc.) ausgelegt ist, die über einen Leitungsschutzschalter 12 (Sicherungsautomat) an das Modul 20 angeschlossen sind. Eingangsseitig ist das Modul 20 an einer Sammelleitung für das Netz 30 (hier nicht dargestellt) angeschlossen. Neben den in Figur 2 bereits gezeigten Schaltelementen 16, dem Energiezähler 11 und den Energieflussrichtungsmessern 14 weist das hier dargestellte Modul 20 vom Modul-Typ 1 21 Anschlüsse 25, 26 für vor geschaltete und nachgeschaltete Module 20 des gleichen Typs auf, so dass diese aneinander reihbar sind. Die Anschlüsse 25 und 26 können ein- oder dreiphasig ausgeführt sein.

Figur 5 zeigt ein universell einsetzbares Modul 20, welches als Modul-Typ 2 22 für Erzeuger 50, 60 ausgelegt ist, die über einen Leitungsschutzschalter 12 (Sicherungsautomat) an das Modul 20 angeschlossen sind. Eingangsseitig ist das Modul 20 an einer Sammelleitung für das Netz 30 (hier nicht dargestellt) angeschlossen. Integriert sind in diesem Modul 20 drei Schaltelemente 16 1_{D}, 1_{E}, 1_{F} sowie ein Energiezähler 11 und zwei Energieflussrichtungsmesser 14 R1_{D}, R1_{F}. Die gegenüber dem in Figur 2 gezeigten Schaltelement 16 3 (entsprechend Schaltelement 16 1_{D} in Figur 5) zusätzlichen Schaltelemente 16 1_{E}, 1_{F} können genutzt werden, wenn mehrere Module 20 diesen Typs parallel verschaltet werden, und die einzelnen Erzeuger unabhängig voneinander für Eigenversorgung oder Netzeinspeisung verschaltet werden. Der Modultyp 2 22 weist in diesem Zusammenhang in der hier dargestellten Form Anschlüsse 23, 24 für gemeinsame Koppelpunkte (z. B. in Form einer ein- oder dreiphasigen Sammelschiene) innerhalb der Stromverteilung 10 aus Figur 1 auf.

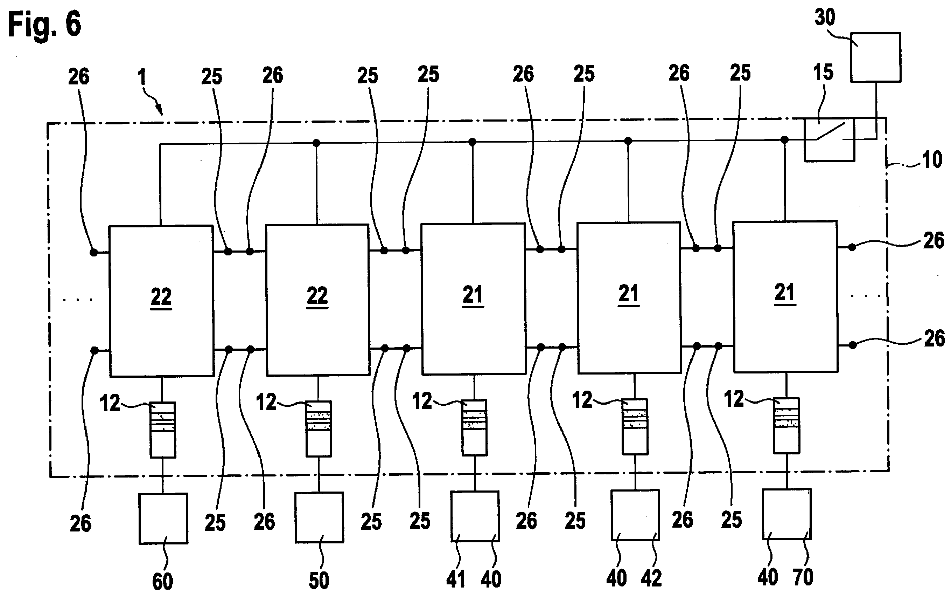

In Figur 6 ist eine Stromverteilung 10 eines Energiemanagement-Netzwerkes 1 mit zwei Erzeugern 50, 60 und drei Verbrauchern 40, wobei zusätzlich zu der in Figur 2 gezeigten Stromverteilung 10 beispielhaft eine Ladestation für ein Elektrofahrzeug 70 als zusätzlicher Verbraucher 40 und eine Kraftwärmekopplung 50 als zusätzlicher Erzeuger hinzu gekommen ist. Die Module vom Modultyp 1 21 für die verschiedenen Verbraucher 40, 41, 42, 70 und die Module vom Modultyp 2 22 für die verschiedenen Erzeuger 50, 60 sind, wie in Figur 4 beispielhaft am Modultyp 1 21 gezeigt, mit Anschlüssen 25 bzw. 26 für vor- und nachgeschaltete Module ausgerüstet. Bei den jeweils äußersten Modulen bleiben die Anschlüsse 26 offen für eine spätere Erweiterung. Alle Module 21, 22 sind über eine Sammelschiene und einen Hauptschalter 15 mit dem Netz 30 verbunden. Erzeuger und Verbraucher 40 sind über Leitungsschutzschalter 12 mit den Modulen 21, 22 verbunden. Module für Einspeiser (Modultyp 2 22) und Verbraucher (Modultyp 1 21) können auch gemischt montiert werden.

An dieser Stelle sei erwähnt, dass ein Eigenverbrauch auch dann vorliegt, wenn die Einspeisung bei einem mehrphasigen Netz auf der einen Phase und der Verbrauch auf einer anderen Phase erfolgt. Daher ist beim Einsatz an einem dreiphasigen Hausanschluss, wie er beispielsweise in Deutschland üblich ist, alles dreiphasig auszuführen. Bei einem einphasigen Hausanschluss ist entsprechend nur eine einphasige Ausführung erforderlich.

Die Energiezähler 11, die Energieflussrichtungsmesser 14 sowie die Schaltelemente 16 innerhalb der Module 20, 21, 22 sind vorzugsweise als elektronische Bauelemente ausgeführt. Die Auswertung sowie ein Schaltalgorithmus zur Ansteuerung der Schaltelemente 16 ist als Software in der Energiemanagementeinheit implementiert. In einer weiteren Ausführungsform kann die Bilanzierung vollständig mittels einer Software vorgenommen werden. Die einzelnen Abgänge zu Verbrauchern 40, 41, 42, 70 und Erzeugern 50, 60 haben dann jeweils eigene physikalische Energiezähler 11, die die jeweils aktuelle Leistung an einen zentralen Rechner übergeben. Schalteinrichtungen und Leistungsrichtungsmessungen sowie die Zählwerke für die Abrechnung sind dann in einer Software implementiert.

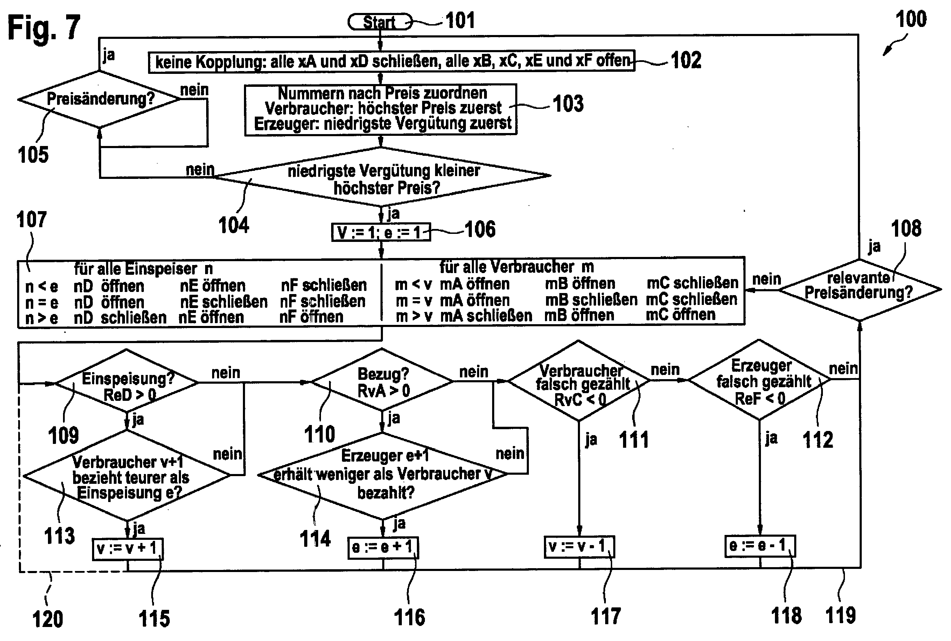

Ein hierfür anzuwendender Schaltalgorithmus ist beispielhaft in Figur 7 als Ablaufdiagramm 100 dargestellt.

Beim Start 101 werden im Funktionsblock I 102 zunächst alle Verbraucher und Erzeuger entkoppelt, wobei alle Schaltelemente 16 m_{A} und n_{D}, geschlossen und die Schaltelemente 16 m_{B}, m_{C} bzw. n_{E}, n_{F} geöffnet sind, wobei m für das m-te Modul vom Modul-Typ 1 21 für Verbraucher 40 und n für das n-te Modul vom Modul-Typ 2 22 für Erzeuger steht. Im Funktionsblock II 103 erfolgt eine Sortierung, wobei die Verbraucher 40 oder Verbrauchergruppen beginnend mit einem aktuell höchsten Bezugspreis und die Erzeuger beginnend mit einer niedrigsten Einspeisevergütung indiziert werden. In einer Abfrage I 104 wird ermittelt, ob die niedrigste Vergütung kleiner ist als der höchste Bezugspreis. Ist dies nicht der Fall wird in einer Abfrage II 105 ermittelt, ob eine Preisänderung vorliegt. Ist dies der Fall, verzweigt der Ablauf zum Funktionsblock I 102, um eine erneute Indizierung vorzunehmen.

Ist als Ergebnis der Abfrage I 104 die niedrigste Vergütung größer oder gleich dem höchsten Bezugspreis, werden im Funktionsblock III 106 die Variablen v und e jeweils gleich 1 gesetzt und gemäß dem nachfolgenden Funktionsblock IV 107 entsprechend die Schaltelemente 16 der Module 20 gesetzt (siehe Inhalt Funktionsblock IV 107, Figur 7), wobei v die Anzahl der Verbraucher bzw. Verbrauchergruppen und e die Anzahl der Erzeuger angibt, die mit dem Kopplungspunkt verschaltet werden. Die übrigen Erzeuger und Verbraucher bzw. Verbrauchergruppen werden getrennt am Netz betrieben.

In den nachfolgenden Abfragen IV, V, VI, VII, VIII, IX 109, 110, 111, 112, 113, 114 wird ermittelt, ob, abhängig von den aktuellen Verbrauchspreisen und den Einspeisevergütungen der einzelnen Verbraucher 40 oder Verbrauchergruppen sowie den Erzeugern, es wirtschaftlich ist, weitere Verbraucher oder Erzeuger zur Kopplung dazu zuschalten (Erhöhung von v bzw. e) oder von der Kopplung zu trennen (Verringerung von v bzw. e), wobei die Zuschaltung von Verbrauchern im Zähler I 115, die Zuschaltung von Erzeugern im Zähler II 116 erfolgt.

Eine Alternative zum Rücksprung bei jeder relevanten Preisänderung sind folgende Abfragen (parallel zur Abfrage VII 113 und zum Zähler I 115 bzw. parallel zur Abfrage IX 114 und zum Zähler II 116):
- Verbrauchertarif niedriger als Einspeisung? Falls ja, wird in Zähler III 117 v reduziert.
- Verbrauchstarif höher als Einspeisung? Falls ja, wird in Zähler IV 118 e reduziert.

Insgesamt werden mit diesem Algorithmus und mittels der Schaltelemente 16 die Erzeuger und Verbraucher 40 oder Verbrauchergruppen derart gekoppelt, dass möglichst viele Verbraucher 40 oder Verbrauchergruppen mit hohen Bezugspreisen mit Erzeugern mit niedrigen Einspeisevergütungen verbunden werden.

Diese Abfolge des Schaltalgorithmus wird über einen Pfad A 119 mit der Abfrage III 108 abgeschlossen, in der geprüft wird, ob eine relevante Preisänderung inzwischen vorliegt. Ist dies der Fall, verzweigt der Ablauf zum Funktionsblock I 102, um eine erneute Indizierung vorzunehmen. Ist dies nicht der Fall, verzweigt der Ablauf zum Funktionsblock IV 107. Damit wird bei Änderungen in der jeweiligen Einspeisevergütung für die Erzeuger und/ oder bei Änderungen der jeweiligen Verbrauchspreise für die Verbraucher 40 oder Verbrauchergruppen eine erneute Indizierung für die Verbraucher 40 oder Verbrauchergruppen und die Erzeuger durchgeführt und entsprechend die Kopplungen und deren Anzahl aktualisiert.

Weiterhin ist vorgesehen, dass bei einer Tarifänderung, bei der die niedrigste Einspeisevergütung ≥ dem höchsten Verbrauchspreis ist, ein Eigenverbrauch unterbunden wird und eine direkte Einspeisung der von dem oder den Erzeugern erzeugte Energie in ein Netz 30 erfolgt (vgl. Abfrage 104).

Nach den letzten Schritten sind mehrere Algorithmus-Alternativen möglich, die keinen Einfluss auf die Ergebnisse haben. So kann beispielsweise vorgesehen sein, dass in einer Verfahrensvariante der Schaltalgorithmus über einen Pfad B 120 abgeschlossen wird.

Mit dem vorgestellten Verfahren und der entsprechenden Vorrichtung zur Durchführung dieses Verfahrens kann eine optimale Ausnutzung preiswert erzeugter Energie zur Deckung eines Verbrauchs mit hohen Kosten erzielt werden, wobei aktuelle Einspeise- und Verbrauchstarife verschiedener Dienstleister berücksichtigt werden können, was zukünftige intelligente Energiemanagementsysteme für Niederspannungsnetze in Gebäuden odgl. unterstützt.

## Patentansprüche

1. Vorrichtung für ein Energiemanagement in Form von mindestens einer Energiemanagementeinheit zur Optimierung von Lasten und Erzeugung in einem Energiemanagement-Netzwerk (1), wobei die Vorrichtung zum Anschluss in einer Stromverteilung (10) wenigstens eines elektrischen Verbrauchers (40) oder einer Verbrauchergruppe und mindestens eines Erzeugers diesen zugeordnete Bauelemente in Form von Schaltelementen (16) und Energiezähler (11) aufweist, welche über eine Verbindung zur Energiemanagementeinheit von dieser beeinflussbar oder auswertbar sind, **dadurch gekennzeichnet, dass** die Schaltelemente (16) in Form einer Schaltmatrix angeordnet sind und damit Energiezähler (11) für Erzeuger und Verbraucher (40) oder Verbrauchergruppen in Serie oder parallel, abhängig von einem jeweiligen aktuellen Einspeise- oder Verbrauchstarif, die von der Energiemanagementeinheit von unterschiedlichen Energiedienstleistern empfangen werden, schaltbar sind, wobei, in der Schaltmatrix integriert, jedem Erzeuger und jedem Verbraucher (40) oder jeder Verbrauchergruppe ein Energiezähler (11) und ein oder mehrere Energieflussrichtungsmesser (14) zur Abrechnung zugeordnet sind.

2. Vorrichtung nach Anspruch 1, **dadurch gekennzeichnet, dass** für jeden Verbraucher (40) m oder für jede Verbrauchergruppe m und jedem Erzeuger n jeweils drei Schaltelemente (16) m_{A}, m_{B}, m_{C} oder n_{D}, n_{E}, n_{F} ein Energiezähler (11) und ein oder zwei Energieflussrichtungsmesser (14) Rm_{C}, Rm_{A} oder Rn_{D}, Rn_{F} zu geordnet sind, wobei einer der Energieflussrichtungsmesser (14) in einem der Energiezähler (11) integriert sein kann.

3. Vorrichtung nach Anspruch 1 oder 2, **dadurch gekennzeichnet, dass** die jeweils drei Schaltelemente (16) m_{A}, m_{B}, m_{C} oder n_{D}, n_{E}, n_{F}, der Energiezähler (11) und die ein oder zwei Energieflussrichtungsmesser (14) Rm_{C}, Rm_{A} oder Rn_{D}, Rn_{F} für jeden Verbraucher (40) m bzw. für jede Verbrauchergruppe m und jeden Erzeuger n in Modulen (20) zusammengefasst sind, wobei den Verbrauchern (40) bzw. den Verbrauchergruppen und den Erzeugern zwei unterschiedliche Modul-Typen 1 und 2 (21, 22) zugeordnet sind.

4. Vorrichtung nach einem der Ansprüche 1 bis 3, **dadurch gekennzeichnet, dass** der Modultyp 1 (21) und Modultyp 2 (22) für die jeweiligen Verbraucher (40) m oder die jeweiligen Verbrauchergruppen m und für die jeweiligen Erzeuger n aneinanderreihbar sind und Anschlüsse (25, 26) für vor geschaltete und nachgeschaltete Module (20) aufweisen.

5. Vorrichtung nach einem der Ansprüche 1 bis 4, **dadurch gekennzeichnet, dass** der Modultyp 1 (21) und der Modultyp 2 (22) für die jeweiligen Verbraucher (40) m oder die jeweiligen Verbrauchergruppen m und für die jeweiligen Erzeuger n Anschlüsse für gemeinsame Koppelpunkte 1 und 2 (23, 24) innerhalb der Stromverteilung (10) aufweisen.

6. Vorrichtung nach einem der Ansprüche 1 bis 5, **dadurch gekennzeichnet, dass** die Energiezähler (11), die Energieflussrichtungsmesser (14) sowie die Schaltelemente (16) als elektronische Bauelemente ausgeführt sind und die Auswertung und einem Schaltalgorithmus zur Ansteuerung der Schaltelemente (16) als Software in der Energiemanagementeinheit implementiert ist.

7. Verfahren zur elektrischen Verbrauchs- und Erzeugungserfassung in einem Energiemanagement-Netzwerk (1), welches mindestens eine Energiemanagementeinheit aufweist und wobei in einer Stromverteilung (10) eine Anzahl von elektrischen Verbrauchern (40) oder Verbrauchergruppen und eine Anzahl von Erzeugern mittels zugeordneten Bauelementen in Form von Schaltelementen (16) und Energiezählern (11), welche von der Energiemanagementeinheit beeinflusst bzw. ausgewertet werden, verschaltet werden, **dadurch gekennzeichnet, dass** mittels eines Schaltalgorithmus die Verbraucher (40) oder Verbrauchergruppen beginnend mit einem aktuell höchsten Bezugspreis und die Erzeuger beginnend mit einer niedrigsten Einspeisevergütung indiziert und mittels der Schaltelemente (16) die Erzeuger und Verbraucher (40) oder Verbrauchergruppen derart gekoppelt werden, dass die Anzahl der Kopplungen von Verbrauchern (40) oder Verbrauchergruppen mit hohen Bezugspreisen mit Erzeugern mit niedrigen Einspeisevergütungen maximiert wird.

8. Verfahren nach Anspruch 7, **dadurch gekennzeichnet, dass** in Abfragen (109, 110, 111, 112, 113, 114) ermittelt wird, ob, abhängig von den aktuellen Verbrauchspreisen und den Einspeisevergütungen der einzelnen Verbraucher (40) oder Verbrauchergruppen sowie der Erzeuger, und/ oder abhängig von der Energieflussrichtung, weitere Verbraucher oder Erzeuger zur Kopplung dazu geschaltet oder von der Kopplung getrennt werden.

9. Verfahren nach Anspruch 7 oder 8, **dadurch gekennzeichnet, dass** bei Änderungen in der jeweiligen Einspeisevergütung für die Erzeuger und/ oder bei Änderungen der jeweiligen Verbrauchspreise für die Verbraucher (40) oder Verbrauchergruppen eine erneute Indizierung für die Verbraucher (40) oder Verbrauchergruppen und die Erzeuger durchgeführt und entsprechend die Kopplungen und deren Anzahl aktualisiert wird.

10. Verfahren nach Anspruch 9, **dadurch gekennzeichnet, dass** bei einer Tarifänderung, bei der die niedrigste Einspeisevergütung ≥ dem höchsten Verbrauchspreis ist, ein Eigenverbrauch unterbunden wird und eine direkte Einspeisung der von dem oder den Erzeugern erzeugte Energie in ein Netz (30) erfolgt.

11. Verfahren nach einem der Ansprüche 7 bis 10, **dadurch gekennzeichnet, dass** nach einer Reduzierung der Anzahl der gekoppelten Erzeuger und Verbraucher (40) eine erneute Erhöhung der Anzahl für eine bestimmte Zeit unterbunden wird.

12. Verfahren nach einem der Ansprüche 7 bis 11, **dadurch gekennzeichnet, dass** der oder die aktuell ermittelten Einspeise- bzw. Verbrauchspreise steuerbaren Erzeugern bzw. Verbrauchern (40) übermittelt werden.

13. Verfahren nach einem der Ansprüche 7 bis 12, **dadurch gekennzeichnet, dass** bei jedem Schaltvorgang zuerst alle Schließvorgänge und dann alle Öffnungsvorgänge ausgeführt werden.

## Claims

1. Apparatus for energy management in the form of at least one energy management unit for optimizing loads and production in an energy management network (1), wherein the apparatus has, for connection in a power distribution system (10) for at least one electrical load (40) or a group of loads and at least one producer, components associated with these in the form of switching elements (16) and energy meters (11) that are able to be influenced or evaluated by the energy management unit via a connection thereto, **characterized in that** the switching elements (16) are arranged in the form of a switching matrix and hence energy meters (11) for producers and loads (40) or groups of loads can be connected in series or parallel, depending on a respective present supply or consumption tariff, which are received by the energy management unit from different energy service providers, wherein, incorporated in the switching matrix, each producer and each load (40) or each group of loads has an associated energy meter (11) and one or more associated energy flow direction meters (14) for billing.

2. Apparatus according to Claim 1, **characterized in that** three respective switching elements (16) m_{A}, m_{B}, m_{C} or n_{D}, n_{E}, n_{F}, an energy meter (11) and one or two energy flow direction meter(s) (14) Rm_{C}, Rm_{A} or Rn_{D}, Rn_{F} are allocated for each load (40) m or for each group of loads m and each producer n, one of the energy flow direction meters (14) being able to be incorporated in one of the energy meters (11).

3. Apparatus according to Claim 1 or 2, **characterized in that** the three respective switching elements (16) m_{A}, m_{B}, m_{C} or n_{D}, n_{E}, n_{F}, the energy meter (11) and the one or two energy flow direction meter(s) (14) Rm_{C}, Rm_{A} or Rn_{D}, Rn_{F} for each load (40) m or for each group of loads m and each producer n are combined in modules (20), the loads (40) or the groups of loads and the producers having two different associated module types 1 and 2 (21, 22).

4. Apparatus according to one of Claims 1 to 3, **characterized in that** the module type 1 (21) and module type 2 (22) for the respective loads (40) m or the respective groups of loads m and for the respective producers n can be strung together and have ports (25, 26) for upstream and downstream modules (20).

5. Apparatus according to one of Claims 1 to 4, **characterized in that** the module type 1 (21) and the module type 2 (22) for the respective loads (40) m or the respective groups of loads m and for the respective producers n have ports for common coupling points 1 and 2 (23, 24) within the power distribution system (10).

6. Apparatus according to one of Claims 1 to 5, **characterized in that** the energy meters (11), the energy flow direction meters (14) and the switching elements (16) are in the form of electronic components, and the evaluation and a switching algorithm for actuating the switching elements (16) are implemented as software in the energy management unit.

7. Method for electrical load and production sensing in an energy management network (1) that has at least one energy management unit and wherein a number of electrical loads (40) or groups of loads and a number of producers in a power distribution system (10) are connected up by means of associated components in the form of switching elements (16) and energy meters (11) that are influenced or evaluated by the energy management unit, **characterized in that** a switching algorithm is used to index the loads (40) or groups of loads starting at a currently highest purchase price and the producers starting at a lowest supply fee, and the switching elements (16) are used to couple the producers and loads (40) or groups of loads such that the number of couplings between loads (40) or groups of loads with high purchase prices and producers with low supply fees is maximized.

8. Method according to Claim 7, **characterized in that** queries (109, 110, 111, 112, 113, 114) are used to ascertain whether, on the basis of the present consumption prices and the supply fees for the individual loads (40) or groups of loads and also the producers, and/or on the basis of the energy flow direction, further loads or producers are connected to the coupling or isolated from the coupling.

9. Method according to Claim 7 or 8, **characterized in that** in the event of changes in the respective supply fee for the producers and/or in the event of changes in the respective consumption prices for the loads (40) or groups of loads, the loads (40) or groups of loads and the producers have fresh indexing performed for them and accordingly the couplings and the number thereof are updated.

10. Method according to Claim 9, **characterized in that** in the event of a tariff change in which the lowest supply fee is ≥ the highest consumption price, private consumption is prohibited and the energy produced by the producer(s) is supplied directly to a grid (30).

11. Method according to one of Claims 7 to 10, **characterized in that** following a reduction in the number of coupled producers and loads (40) a fresh increase in the number is prohibited for a particular time.

12. Method according to one of Claims 7 to 11, **characterized in that** the currently ascertained supply or consumption price(s) are transmitted to controllable producers or loads (40).

13. Method according to one of Claims 7 to 12, **characterized in that** each switching operation involves firstly all closing operations and then all opening operations being performed.

## Revendications

1. Dispositif de gestion d'énergie présentant la forme d'au moins une unité de gestion d'énergie destinée à optimiser les charges et la génération d'énergie dans un réseau (1) de gestion d'énergie, tandis que pour le raccordement d'au moins un consommateur électrique (40) ou d'un groupe de consommateurs électriques et d'au moins un générateur d'énergie dans un répartiteur de courant (10), le dispositif présente des composants associés à ces derniers et présentant la forme d'éléments de commutation (16) et de compteurs d'énergie (11) qui peuvent être influencés ou évalués par l'unité de gestion d'énergie par l'intermédiaire d'une liaison à cette unité de gestion d'énergie,
**caractérisé en ce que**
les éléments de commutation (16) sont disposés en matrice de commutation,
**en ce que** des compteurs d'énergie (11) des générateurs et des consommateurs (40) ou des groupes de consommateurs peuvent être commutés en série ou en parallèle en fonction du tarif en cours d'injection ou de consommation qui est reçu par l'unité de gestion d'énergie en provenance de différents services de distribution d'énergie et
**en ce qu'**un compteur d'énergie (11) et un ou plusieurs dispositifs (14) de mesure de la direction d'écoulement de l'énergie servant à effectuer les décomptes sont intégrés dans la matrice de commutation et sont associés à chaque générateur et à chaque consommateur (40) ou chaque groupe de consommateurs.

2. Dispositif selon la revendication 1, **caractérisé en ce que** trois éléments de commutation (16) m_{A}, m_{B}, m_{C} ou n_{D}, n_{E}, n_{F}, un compteur d'énergie (11) et un ou deux dispositifs (14) Rm_{C}, Rm_{A} ou Rn_{D}, Rn_{F} de mesure de la direction d'écoulement de l'énergie sont associés à chaque consommateur (40) m ou à chaque groupe de consommateurs m et à chaque générateur n et **en ce que** l'un des dispositifs (14) de mesure de la direction d'écoulement de l'énergie peut être intégré dans l'un des compteurs d'énergie (11).

3. Dispositif selon les revendications 1 ou 2, **caractérisé en ce que** les trois éléments de commutation (16) M_{A}, m_{B}, m_{C} ou n_{D}, n_{E}, n_{F}, le compteur d'énergie (11) et le ou les deux dispositifs (14) Rm_{C}, Rm_{A}, ou Rn_{D}, Rn_{F} de mesure de la direction d'écoulement de l'énergie prévus pour chaque consommateur (40) m ou pour chaque groupe m de consommateurs et pour chaque générateur n sont rassemblés en modules (20), deux différents types 1 et 2 (21, 22) de modules étant associés aux consommateurs (40) ou groupes de consommateurs et aux générateurs.

4. Dispositif selon l'une des revendications 1 à 3, **caractérisé en ce que** le type 1 (21) de module et le type 2 (22) de module prévus pour chaque consommateur (40) m ou chaque groupe m de consommateurs et pour chaque générateur n peuvent être mis en série et présentent des bornes de raccordement (25, 26) pour des modules (20) raccordés en amont et raccordés en aval.

5. Dispositif selon l'une des revendications 1 à 4, **caractérisé en ce que** le type 1 (21) de module et le type 2 (22) de module prévus pour chaque consommateur (40) m ou chaque groupe de consommateurs m et pour chaque générateur n présentent des bornes de raccordement pour des points communs de raccordement 1 et 2 (23, 24) à l'intérieur de la répartition de courant (10).

6. Dispositif selon l'une des revendications 1 à 5, **caractérisé en ce que** les compteurs d'énergie (11), les dispositifs (14) de mesure de la direction d'écoulement de l'énergie ainsi que les éléments de commutation (16) sont réalisés sous la forme de composants électroniques et **en ce que** l'évaluation et un algorithme de commutation destiné à commander les éléments de commutation (16) sont mis en oeuvre sous la forme de logiciels dans l'unité de gestion de l'énergie.

7. Procédé de détection de la consommation et de la génération d'électricité dans un réseau (1) de gestion de l'énergie qui présente au moins une unité de gestion de l'énergie,
plusieurs consommateurs électriques (40) ou groupes de consommateurs et plusieurs générateurs étant raccordés au moyen de composants associés qui présentent la forme d'éléments de commutation (16) et de compteurs d'énergie (11) que l'unité de gestion d'énergie peut influencer ou évaluer étant raccordés dans une répartition de courant (10),
**caractérisé en ce que**
les consommateurs (40) ou groupes de consommateurs sont indexés au moyen d'un algorithme de commutation en commençant avec le prix de référence le plus élevé en cours, les commutateurs étant indexés en commençant avec la valorisation d'injection la plus basse et
**en ce que** les générateurs et les consommateurs (40) ou groupes de consommateurs sont raccordés au moyen des éléments de commutation (16) de telle sorte que le nombre de raccordements de consommateurs (40) ou de groupe de consommateurs qui présentent les prix de référence les plus élevés à des générateurs qui présentent la valorisation d'injection la plus basse soit maximisé.

8. Procédé selon la revendication 7, **caractérisé en ce qu'**au moyen de demandes (109, 110, 111, 112, 113, 114), il détermine en fonction des prix de consommation et des valorisations d'injection en cours des différents consommateurs (40) ou groupes de consommateurs ainsi que des générateurs et/ou en fonction de la direction d'écoulement de l'énergie, si d'autres consommateurs ou générateurs doivent être branchés ou débranchés.

9. Procédé selon les revendications 7 ou 8, **caractérisé en ce qu'**en cas de modification de la valorisation d'injection des générateurs et/ou en cas de modification du prix de consommation des consommateurs (40) ou groupes de consommateurs, une nouvelle indexation des consommateurs (40) ou groupes de consommateurs et des générateurs est réalisée et actualisée en fonction des raccordements et de leur nombre.

10. Procédé selon la revendication 9, **caractérisé en ce qu'**au cas où une modification de tarif pour laquelle la valorisation d'injection la plus basse est ≥ au prix de consommation le plus haut, la consommation d'énergie est bloquée et l'énergie délivrée par le ou les générateurs est injectée directement dans un réseau (30).

11. Procédé selon l'une des revendications 7 à 10, **caractérisé en ce qu'**après réduction du nombre des générateurs et consommateurs (40) raccordés, une nouvelle augmentation du nombre est bloquée pendant une durée définie.

12. Procédé selon l'une des revendications 7 à 11, **caractérisé en ce que** le ou les prix d'injection ou de consommation déterminés à chaque instant sont transmis aux générateurs ou consommateurs (40) asservis.

13. Procédé selon l'une des revendications 7 à 12, **caractérisé en ce que** lors de chaque opération de commutation, toutes les opérations de fermeture sont d'abord réalisées, les opérations d'ouverture étant réalisées ensuite.
